# EUROPEAN PATENT APPLICATION

(11) **EP 0 741 458 A1**
(43) Date of publication of application: **06.11.1996**
(21) Application number: 96302849.3
(22) Date of filing: 23.04.1996
(51) Int. Cl.: H03K 19/003, H03K 19/0185

(54) **Integrated circuit output buffer**

(30) Priority: 02.05.1995 GB 9508886
(71) Applicant: PLESSEY SEMICONDUCTORS LIMITED, Swindon, Wiltshire SN2 2QW (GB)
(72) Inventor: Wilcox, David John, Stratton St Margaret, Swindon, Wiltshire (GB)
(74) Representative: Hoste, Colin Francis

(57) **Abstract**

A buffer circuit arrangement for an output of an integrated circuit which is required to operate over a reduced voltage range, in which the reduced voltage range is defined by a passive circuit from which reduced limit voltages are applied to respective feedback amplifiers supplying current to the output buffer stage.

## Description

The present invention relates to output buffers or drivers for integrated circuits such as, for example, frequency synthesizers.

Complementary - symmetry metal oxide semiconductor (CMOS) integrated circuits commonly are energised from a five volt supply, with signal levels within the integrated circuit, or chip, switching substantially between the potentials on the supply conductors. A major problem with standard output buffers utilising the full five-volt swing is that adjacent circuits or devices can pick up unwanted signals from these output buffers. In order to minimise this effect output buffers have been proposed which operate over a reduced output voltage range, with defined limit voltages being applied to the output buffers by way of source follower circuits.

According to one aspect of the present invention in an integrated circuit which is arranged to be energised from a supply source providing predetermined potentials to supply conductors of said integrated circuit, an output buffer arrangement comprises at least one output transistor device which is arranged to provide output signals of said integrated circuit in response to signals applied to a control electrode thereof, and feedback amplifier means to conduct current between a terminal of said transistor device and one of said supply conductors while maintaining that terminal of said transistor device substantially at a potential intermediate the potentials on said supply conductors.

According to another aspect of the present invention in an integrated circuit which is arranged to be energised from a supply source providing respective different potentials to supply conductors of the integrated circuit, an output buffer arrangement comprises a complementary pair of output transistor devices having their drain electrodes connected together and to an output terminal of the integrated circuit, and first and second feedback amplifier means arranged to conduct current between respective ones of said supply conductors and the source electrodes of respective ones of said pair of transistors while maintaining said source electrodes substantially at respective predetermined potentials intermediate the potentials on said supply conductors.

An output buffer arrangement for an integrated circuit will now be described by way of example with reference to the accompanying drawings, of which:-
Figure 1 shows the output buffer arrangement schematically,
Figures 2 and 3 show diagrammatically respective parts of the arrangement shown in Figure 1,
Figure 4 shows diagrammatically a form of transistor device utilised in the arrangement of Figure 1, and
Figure 5 shows diagrammatically a current source arrangement utilised in the arrangement of Figure 1.

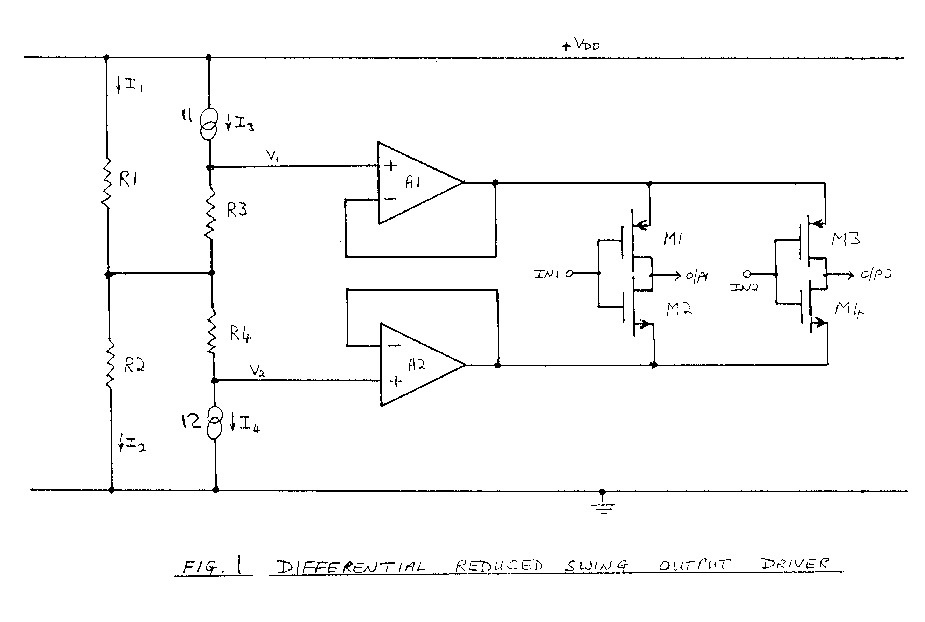

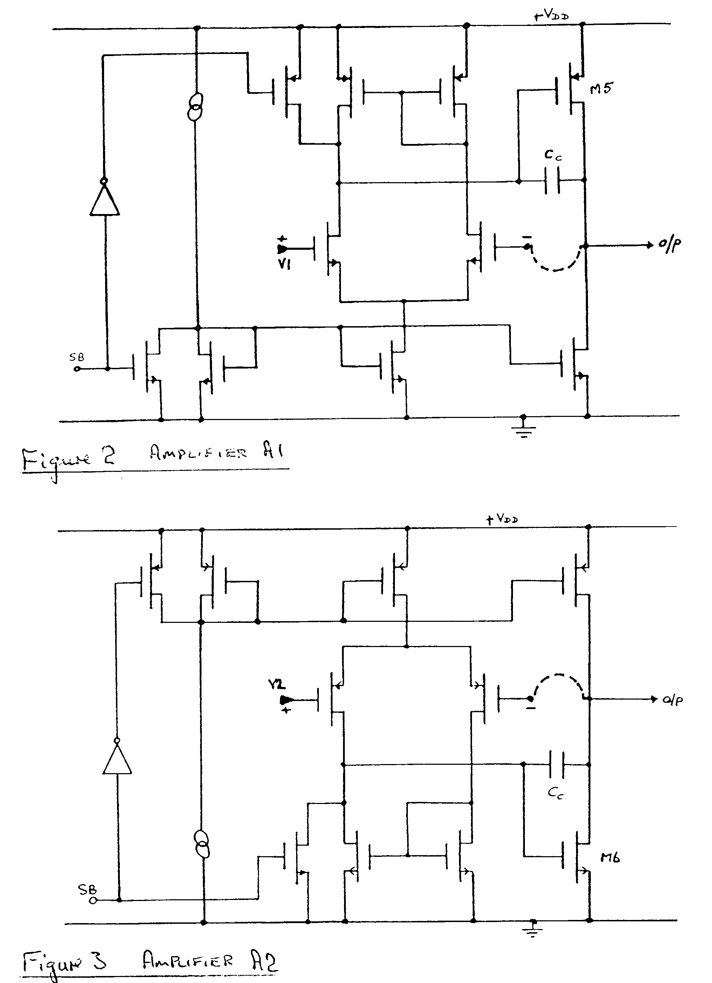

Referring to Figure 1, the output buffer arrangement comprises a network comprising resistors R1 to R4 for defining a mid-point voltage between the voltage of the positive supply conductor 1 and that of the return supply conductor 2, and for defining voltages V1 and V2 symmetrically above and below that mid-point voltage. The voltages V1 and V2 are applied to the non-inverting inputs of high-gain voltage follower amplifiers Al and A2 respectively, these amplifiers being shown in greater detail in Figures 2 and 3. By virtue of the respective feedback connections to their inverting inputs, indicated in dashed lines in Figures 2 and 3, these amplifiers operate to maintain their output terminals substantially at V1 and V2 respectively, to act as supply voltages for output stages comprising transistors M1, M2 and M3, M4.

The voltages V1 and V2 differ from the mid-point voltage respectively by the voltage drops across the resistors R3 and R4, carrying currents I3 and I4 respectively, and the accuracy with which these voltages are defined will depend on the matching accuracy of the resistors R1, R2 and R3, R4, and the sources 11, 12 of the currents I3, I4. As shown in Figure 5, a reference current value Iref may be derived from a band-gap reference voltage source Vref, applied by way of an amplifier A3 and a transistor 51 to set up a voltage substantially equal to Vref across a resistor Rref. The current sources 11, 12 may then be constituted by current mirror circuits (not shown) connected such that the values of I3, I4 are dependent upon the value of Iref. If the resistor Rref is formed of the same material as the resistors R1 to R4, the voltages V1 and V2 will to a first order be independent of the sheet resistivity of that material, and these voltages will also to a first order be independent of the supply voltage VDD and of resistor temperature effects. This gives better toleranced voltages V1 and V2 than would be attainable by merely connecting a resistive potential divider between VDD and earth potential.

Referring now in particular to Figures 2 and 3, the amplifiers A1 and A2 are operational amplifiers having differential inputs and single-ended outputs, the amplifier Al having a PMOS common source output device M5 and the amplifier A2 having an NMOS common source output device M6. As indicated above the voltage V1 maintained at the output of amplifier Al is more positive then the mid-point of the supply voltage while the voltage V2 at the output of the amplifier A2 is more negative than the mid-point. Where the output of the buffer arrangement is to interface with, say, a bipolar prescaler the output voltage may be required to have a minimum swing of 0.6 volts peak-to-peak and a maximum swing of 1.1 volts peak-to-peak, the supply voltage VDD being nominally 5 volts.

Under fast transient conditions, for example when the device M1 is switched on to charge a load (not shown) connected to O/P1 to the voltage V1, the output device M5 of the amplifier A1 supplies the required high current by virtue of being effectively connected as a MOSFET diode by way of the compensation capacitor Cc. Thus, assuming for example that the output O/P1 is at V2, with device M2 switched on, when device M2 is switched off and device M1 is switched on the output of the amplifier Al tends to be pulled negative with respect to V1, the action of the capacitor Cc tending to pull the gate electrode of device M5 negative as well, causing a high current to flow to O/P1 to charge the load.

Similarly, when the device M1 is switched off and the device M2 switched on, the output of the amplifier A2 tends to be pulled positive with respect to V2, the compensation capacitor again tending to pull the gate electrode of the output device M6 positive, causing the required high current to flow to charge (or discharge) the load to the voltage V2.

Since the output of amplifier A1 remains at the voltage V1 while the device M1 is switched off, for half a cycle of the output signal the amplifier Al is effectively redundant. The arrangement can therefore support differential outputs O/P1 and O/P2, with the amplifiers A1 and A2 alternately driving each output to V1 and V2 respectively, such that for example when O/P1 is being driven to V2 by way of device M2, O/P2 is being driven to V1 by way of device M3.

The amplifiers A1 and A2 may be switched to a power-down state by applying a positive voltage, or logic High, to inputs SB, which has the effect of removing the input bias currents and driving the gate electrodes of the transistors M5 and M6 to VDD and ground respectively. The amplifiers are thereby made tri-state, making the outputs O/P1 and O/P2 also tri-state.

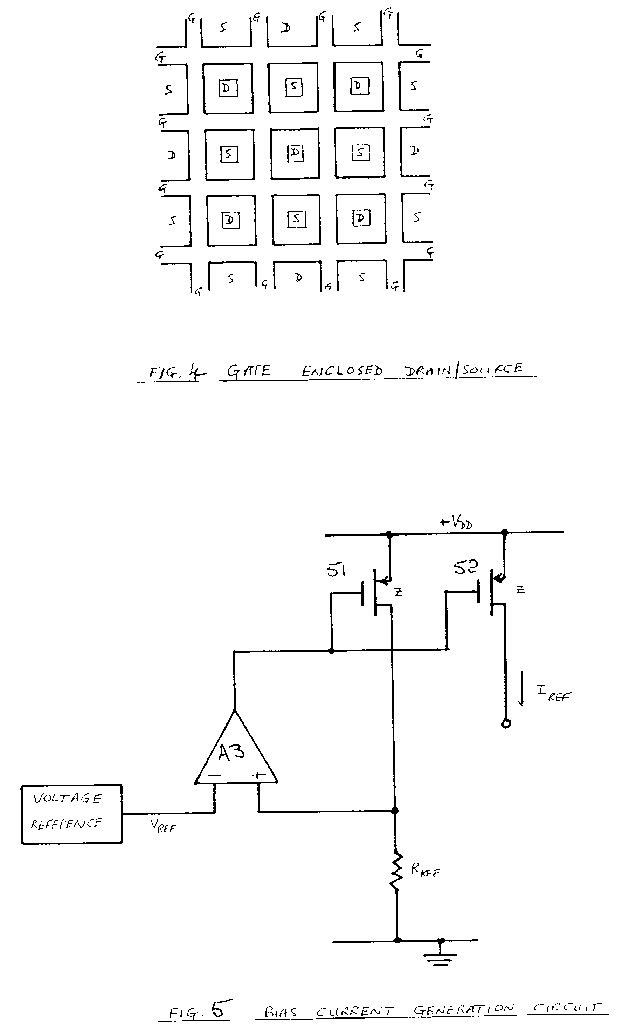

In order to minimise the drain-bulk capacitance of the transistor devices M1 to M6, these transistors may be laid out using the gate-enclosed drain/source configuration, as shown diagrammatically in Figure 4.

## Claims

1. An integrated circuit which is arranged to be energised from a supply source providing predetermined potentials to supply conductors of said integrated circuit, wherein an output buffer arrangement comprises at least one output transistor device which is arranged to provide output signals of said integrated circuit in response to signals applied to a control electrode thereof, and feedback amplifier means to conduct current between a terminal of said transistor device and one of said supply conductors while maintaining that terminal of said transistor device substantially at a potential intermediate the potentials on said supply conductors.

2. An integrated circuit which is arranged to be energised from a supply source providing respective different potentials to supply conductors of the integrated circuit, wherein an output buffer arrangement comprises a complementary pair of output transistor devices having their drain electrodes connected together and to an output terminal of the integrated circuit, and first and second feedback amplifier means arranged to conduct current between respective ones of said supply conductors and the source electrodes of respective ones of said pair of transistors while maintaining said source electrodes substantially at respective predetermined potentials intermediate the potentials on said supply conductors.

3. An integrated circuit in accordance with Claim 2 wherein there are provided passive circuit means to establish said predetermined potentials intermediate the potentials on said supply conductors, said passive circuit means being connected to respective inputs of said first and second feedback amplifier means.

4. An integrated circuit in accordance with Claim 2 or Claim 3 wherein each of said first and second feedback amplifier means is provided with first and second negative feedback paths.

5. An integrated circuit substantially as described with reference to Figure 1 of the accompanying drawings.

6. An integrated circuit substantially as described with reference to Figures 1 to 3 of the accompanying drawings.
